# EUROPÄISCHE PATENTSCHRIFT

(11) **EP 3 949 703 B1**
(45) Veröffentlichungstag und Bekanntmachung des Hinweises auf die Patenterteilung: **03.01.2024**
(21) Anmeldenummer: 19723665.6
(22) Anmeldetag: 23.04.2019
(51) Int. Cl.: H02J 3/18, H05K 7/20, H02M 7/483

(54) **ANORDNUNG MIT EINEM STROMRICHTER**
ARRANGEMENT WITH A CONVERTER
ENSEMBLE AVEC CONVERTISSEUR

(43) Veröffentlichungstag der Anmeldung: 09.02.2022
(73) Patentinhaber: Siemens Energy Global GmbH & Co. KG, 81739 München (DE)
(72) Erfinder: PIESCHEL, Martin, 90518 Altdorf (DE); NAUKAMM, Markus, 91052 Erlangen (DE); NIEMANN, Bernd, 91054 Erlangen (DE)
(86) Internationale Anmeldenummer: PCT/EP2019/060347
(87) Internationale Veröffentlichungsnummer: WO 2020/216432

(56) Entgegenhaltungen:
- WO-A1-2016/134786
- WO-A1-2018/095549
- WO-A1-2018/095552
- DE-A1-102011 012 723
- DE-A1-102016 211 762
- RODRIGUEZ J ET AL: "Multilevel Converters: An Enabling Technology for High-Power Applications", PROCEEDINGS OF THE IEEE, IEEE. NEW YORK, US, Bd. 97, Nr. 11, 1. November 2009 (2009-11-01), Seiten 1786-1817, XP011278598, ISSN: 0018-9219, DOI: 10.1109/JPROC.2009.2030235

## Beschreibung

Die Erfindung betrifft eine Anordnung mit einem Stromrichter, der eine elektrische Reihenschaltung von Modulen aufweist, welche jeweils vier elektronische Schaltelemente und einen elektrischen Energiespeicher aufweisen. Weiterhin betrifft die Erfindung ein Verfahren zum Betreiben einer solchen Anordnung.

Beim Betrieb des Stromrichters müssen die elektronischen Schaltelemente gekühlt werden. Daher weist der Stromrichter eine Kühleinrichtung auf, welche mittels eines flüssigen Kühlmittels und eines Wärmetauschers zum Kühlen der elektronischen Schaltelemente dient. Dabei zirkuliert das flüssige Kühlmittel in einem geschlossenen Kühlkreislauf. Das flüssige Kühlmittel nimmt bei den elektronischen Schaltelementen entstehende Wärme auf und transportiert diese Wärme zu dem Wärmetauscher. Am Wärmetauscher wird die Wärme an ein temperaturaufnehmendes Medium abgegeben und dadurch das flüssige Kühlmittel abgekühlt. Daraufhin gelangt das flüssige Kühlmittel zurück zu den elektronischen Schaltelementen. Das am Wärmetauscher die Wärme aufnehmende Medium kann beispielsweise Luft sein.

Wenn das am Wärmetauscher die Wärme aufnehmende Medium eine Temperatur kleiner als 0°C aufweist, dann besteht die Gefahr, dass das flüssige Kühlmittel einfriert und dabei insbesondere der Wärmetauscher zerstört wird. Um dem entgegen zu wirken, kann dem flüssigen Kühlmittel ein Frostschutzmittel zugesetzt werden, beispielsweise ein Glykol (wie insbesondere Monoethylenglykol oder Propylenglykol). Allerdings steigt durch das Frostschutzmittel der Wärmewiderstand des flüssigen Kühlmittels an, so dass die Wärmeabfuhr von den elektronischen Schaltelementen verschlechtert wird. Außerdem kann durch das Frostschutzmittel die Viskosität des Kühlmittels ansteigen, was auch eine Verschlechterung der Kühleigenschaften der Kühleinrichtung zur Folge hat.

Die deutsche Offenlegungsschrift DE 10 2016 211 762 A1 offenbart ein Verfahren und eine Vorrichtung zur Erwärmung einer Fahrbatterie eines elektrisch antreibbaren Fahrzeugs. Dabei wird eine den elektrischen Antrieb des Fahrzeugs ansteuernde Leistungselektronik derart angesteuert, dass sich aufgrund einer Erhöhung des Oberwellenanteils eine erhöhte Verlustleistung im elektrischen Antrieb ergibt.

Aus der Schrift "Multilevel Converters: An Enabling Technology for High-Power Applications" von J. Rodriguez et al, Proceedings of the IEEE, NEW YORK, Bd. 97, Nr. 11, 1. November 2009, Seiten 1786-1817 (XP011278598) ist es bekannt, einen Multilevel-Stromrichter zur Speisung eines elektrischen Motors einzusetzen.

Die internationale Patentanmeldung WO 2018/095549 A1 offenbart einen modularen Multilevelstromrichter mit einer Kühleinrichtung. Die Kühleinrichtung weist optional auch eine Heizeinrichtung auf, mit der nach einem Unterschreiten eines Temperaturgrenzwertes die Temperatur des Kühlmittels erhöht werden kann. Dadurch verringert sich die Viskosität des Kühlmittels, so dass das Kühlmittel leichter durch den Kühlkreislauf fließen kann. Die Heizeinrichtung ist dabei als ein eigenständiges Bauteil ausgestaltet, das im Kühlkreislauf angeordnet ist.

Der Erfindung liegt die Aufgabe zugrunde, eine Anordnung und ein Verfahren anzugeben, bei denen der Anteil des Frostschutzmittels in dem flüssigen Kühlmittel reduziert werden kann.

Diese Aufgabe wird erfindungsgemäß gelöst durch eine Anordnung und durch ein Verfahren nach den unabhängigen Patentansprüchen. Vorteilhafte Ausführungsformen der Anordnung und des Verfahrens sind in den abhängigen Patentansprüchen angegeben.

Offenbart wird eine Anordnung mit einem Stromrichter, der eine elektrische Reihenschaltung von Modulen aufweist, welche jeweils vier elektronische Schaltelemente und einen elektrischen Energiespeicher aufweisen, mit einer Kühleinrichtung zum Kühlen der elektronischen Schaltelemente mittels eines flüssigen Kühlmittels und eines Wärmetauschers und mit einer Ansteuereinheit zum Ansteuern der elektronischen Schaltelemente, die die elektronischen Schaltelemente so ansteuert, dass in der Reihenschaltung mindestens eine Stromoberschwingung (zu einer von dem Stromrichter zu erzeugenden Stromgrundschwingung) erzeugt wird, wenn die Temperatur des flüssigen Kühlmittels oder die Temperatur eines Mediums, das am Wärmetauscher die Wärme aufnehmen soll, unter eine vorgewählte (vorbestimmte) Grenztemperatur absinkt. Das am Wärmetauscher die Wärme aufnehmende Medium (wärmeaufnehmende Medium) kann Luft sein, kann aber auch eine Flüssigkeit sein. Der Stromrichter kann insbesondere ein modularer Multilevel-Stromrichter sein, der zum Beispiel als ein Blindleistungskompensator, ein Wechselrichter oder ein aktives Filter ausgestaltet ist. Der Stromrichter ist dabei in Dreieckschaltung ausgestaltet.

Hierbei ist vorteilhaft, dass in der Reihenschaltung die Stromoberschwingung erzeugt wird, sobald das Kühlmittel oder das wärmeaufnehmende Medium kälter ist als die vorgewählte Grenztemperatur. Durch die zusätzlich erzeugte Stromoberschwingung fließt ein Strom in der elektrischen Reihenschaltung, welcher zusätzliche elektrische Verluste in den elektronischen Schaltelementen erzeugt. Daraufhin steigt die Temperatur der elektronischen Schaltelemente an und damit auch die Temperatur des flüssigen Kühlmittels. Dadurch wird auch bei einer Temperatur des wärmeaufnehmenden Mediums unterhalb der Grenztemperatur verhindert, dass das flüssige Kühlmittel einfriert. Mit anderen Worten gesagt, wird mittels der Stromoberschwingung das flüssige Kühlmittel aufgeheizt, sobald die Temperatur des wärmeaufnehmenden Mediums unter die Grenztemperatur absinkt. Dadurch ist es ausreichend, wenn das flüssige Kühlmittel mit so viel Frostschutzmittel versehen ist, dass es bis zur Grenztemperatur arbeitsfähig bleibt. Die Menge an Frostschutzmittel braucht vorteilhafterweise nicht für diejenigen (im Allgemeinen selten auftretenden) Zeiten kalkuliert sein, in denen die Temperatur des wärmeaufnehmenden Mediums unter die vorgewählte Grenztemperatur absinken sollte. Für diese (seltenen) Fälle werden die elektronischen Schaltelemente als Heizelemente verwendet. Die vier elektronischen Schaltelemente dienen also zusätzlich als Heizelemente, wenn die Temperatur des Mediums unter die Grenztemperatur absinkt.

Die Anordnung kann so ausgestaltet sein, dass die vorgewählte Grenztemperatur die Frostschutzgrenztemperatur des Kühlmittels ist. Dabei ist die Frostschutzgrenztemperatur die Temperatur, oberhalb der das Kühlmittel flüssig ist. Dann wird die mindestens eine Stromoberschwingung genau dann erzeugt (und damit die elektronischen Schaltelemente als Heizelemente eingesetzt), wenn die Temperatur des Kühlmittels oder die Temperatur des wärmeaufnehmenden Mediums unter die Frostschutzgrenztemperatur des Kühlmittels absinkt. Dadurch wird verhindert, dass selbst bei einem derart kalten Medium das flüssige Kühlmittel anfängt einzufrieren.

Die Anordnung kann auch so ausgestaltet sein, dass die Stromoberschwingung eine nicht zur Kompensation von Oberschwingungen in einem angeschlossenen Wechselspannungsnetz oder in einer angeschlossenen elektrischen Last benötigte Stromoberschwingung ist. Die Stromoberschwingung wird also ausschließlich zu Heizzwecken verwendet. Die Stromoberschwingung wird jedoch nicht zur Kompensation von Oberschwingungen in einem angeschlossenen Wechselspannungsnetz oder einer angeschlossenen elektrischen Last verwendet (wie es beispielsweise bei einem aktiven Filter vorstellbar wäre).

Die Anordnung ist so ausgestaltet, dass die Stromoberschwingung eine Stromoberschwingung n-ter Ordnung (zu der von dem Stromrichter zu erzeugenden Stromgrundschwingung) ist, wobei n ein ganzzahliges Vielfaches von 3 ist. Es wird also beispielsweise die "dritte Stromoberschwingung", die "sechste Stromoberschwingung" oder die "neunte Stromoberschwingung" usw. erzeugt.

Derartige Stromoberschwingungen sind deshalb besonders vorteilhaft, weil sich herausgestellt hat, dass die aufgrund dieser Stromoberschwingungen fließenden Ströme innerhalb des Stromrichters verbleiben und den Stromrichter nicht verlassen. Daher treten außerhalb des Stromrichters (das heißt, beispielsweise in dem an den Stromrichter angeschlossenen Wechselspannungsnetz) keine Veränderungen aufgrund der zusätzlichen Stromoberschwingung auf.

Die Anordnung kann so ausgestaltet sein, dass in der Reihenschaltung mehrere Stromoberschwingungen erzeugt werden, wenn die Temperatur des Kühlmittels oder die Temperatur des Mediums unter die vorgewählte Grenztemperatur absinkt. Der Stromrichter erzeugt also in diesem Fall mehrere unterschiedliche Stromoberschwingungen.

Bei dieser Variante werden also auch Oberschwingungen erzeugt, deren Ordnung größer als 3 ist, also beispielsweise die sechste Stromoberschwingung, die neunte Stromoberschwingung, die zwölfte Stromoberschwingung und so weiter. Um diese Stromoberschwingungen höherer Frequenz zu erzeugen, müssen die elektronischen Schaltelemente schneller schalten als beispielsweise bei der Erzeugung der Oberschwingung dritter Ordnung. Dadurch entstehen in den elektronischen Schaltelementen mehr Schaltverluste, so dass auch aufgrund dieser Schaltverluste das flüssige Kühlmittel aufgeheizt wird.

Die Anordnung kann dabei auch so ausgestaltet sein, dass die mehreren Stromoberschwingungen nicht zur Kompensation von Oberschwingungen in einem angeschlossenen Wechselspannungsnetz oder in einer angeschlossenen elektrischen Last benötigte Stromoberschwingungen sind. Es handelt sich also auch hier um zusätzliche Stromoberschwingungen, welche nicht für den normalen Betrieb des Stromrichters notwendig sind bzw. nicht im normalen Betrieb des Stromrichters entstehen.

Die Anordnung kann auch so ausgestaltet sein, dass die mehreren Stromoberschwingungen voneinander verschiedene Stromoberschwingungen n-ter Ordnung (zu der von dem Stromrichter zu erzeugenden Stromgrundschwingung) sind, wobei n jeweils ein ganzzahliges Vielfaches von 3 ist. Es kann hier also beispielsweise die Stromoberschwingung dritter Ordnung, die Stromoberschwingung sechster Ordnung und/oder die Stromoberschwingung neunter Ordnung usw. erzeugt werden.

Die Anordnung kann auch so ausgestaltet sein, dass der Stromrichter drei elektrische Reihenschaltungen von Modulen aufweist, die in Dreieckschaltung angeordnet sind. Insbesondere bei einem derartigen Stromrichter, welcher drei elektrische Reihenschaltungen in Dreiecksschaltung aufweist, verbleiben die aufgrund der Stromoberschwingungen n-ter Ordnung (wobei n ein ganzzahliges Vielfaches von drei ist) fließenden Ströme innerhalb der Dreieckschaltung; die aufgrund dieser Stromoberschwingungen fließenden Ströme verlassen den Stromrichter nicht.

Die Anordnung kann auch so ausgestaltet sein, dass die mindestens eine Stromoberschwingung einen innerhalb des Stromrichters fließenden Kreisstrom bildet (der den Stromrichter nicht verlässt). Dieser Kreisstrom ist ein stromrichterinterner (Kreis-)Strom und dient insbesondere ausschließlich zum Aufheizen des flüssigen Kühlmittels.

Die Anordnung kann so ausgestaltet sein, dass die Kühleinrichtung eine Einkreis-Kühleinrichtung ist. Aufgrund der bei tiefen Temperaturen des Mediums durchgeführten elektrischen Beheizung des flüssigen Kühlmittels ist eine vergleichsweise einfache und kostengünstige Einkreis-Kühleinrichtung ausreichend. Eine Mehrkreis-Kühleinrichtung, welche in ihrem inneren Kühlkreis an den vier elektronischen Schaltelementen ein flüssiges Kühlmittel ohne oder mit wenig Frostschutzmittelanteil verwenden würde, und in einem äußeren Kühlkreis ein flüssiges Kühlmittel mit mehr Frostschutzmittel (um zu verhindern, dass das flüssige Kühlmittel des äußeren Kühlkreislaufes an dem Wärmetauscher des äußeren Kühlkreislaufes einfriert), ist vorteilhafterweise nicht notwendig. Eine solche Mehrkreis-Kühleinrichtung wäre nämlich mit erheblich höheren Kosten verbunden als eine Einkreis-Kühleinrichtung.

Die Anordnung kann so ausgestaltet sein, dass die Module Vollbrückenmodule sind, bei denen die vier elektronischen Schaltelemente in einer Vollbrückenschaltung angeordnet sind. Mit derartigen Modulen lassen sich besonders einfach die Stromoberschwingungen erzeugen.

Die Anordnung kann auch so ausgestaltet sein, dass die elektrische Reihenschaltung zusätzlich zu den Modulen ein induktives Bauelement aufweist. Ein derartiges induktives Bauelement ermöglicht es insbesondere, den Stromanstieg so zu begrenzen, dass keine Schäden an den Schaltelementen durch Überlastung entstehen.

Die Anordnung kann auch so ausgestaltet sein, dass die mindestens eine Stromoberschwingung nur dann erzeugt wird, wenn zusätzlich der (betriebsbedingt) in der Reihenschaltung fließende Betriebsstrom des Stromrichters einen Stromschwellenwert unterschreitet. Der Stromschwellenwert ist insbesondere der minimale Stromwert, der in den elektronischen Schaltelementen eine ausreichende Wärmemenge erzeugt, um ein Einfrieren des Kühlmittels zu verhindern.

Offenbart wird weiterhin ein Verfahren zum Betreiben einer Anordnung mit einem Stromrichter, der eine elektrische Reihenschaltung von Modulen aufweist, welche jeweils vier elektronische Schaltelemente und einen elektrischen Energiespeicher aufweisen, und mit einer Kühleinrichtung zum Kühlen der elektronischen Schaltelemente mittels eines flüssigen Kühlmittels und eines Wärmetauschers, wobei bei dem Verfahren die Temperatur des flüssigen Kühlmittels und/oder die Temperatur eines Mediums, das am Wärmetauscher die Wärme aufnehmen soll, ermittelt wird, und bei einem Absinken der Temperatur des Kühlmittels und/oder der Temperatur des Mediums unter eine vorgewählte/vorbestimmte Grenztemperatur die elektronischen Schaltelemente so angesteuert werden, dass in der Reihenschaltung mindestens eine Stromoberschwingung (zu der von dem Stromrichter zu erzeugenden Stromgrundschwingung) erzeugt wird.

Dieses Verfahren läuft so ab, dass die Stromoberschwingung eine Stromoberschwingung n-ter Ordnung (zu der von dem Stromrichter zu erzeugenden Stromgrundschwingung) ist, wobei n ein ganzzahliges Vielfaches von 3 ist.

Das Verfahren kann auch so ablaufen, dass in der Reihenschaltung mehrere Stromoberschwingungen (zu der von dem Stromrichter zu erzeugenden Stromgrundschwingung) erzeugt werden, wenn die Temperatur des Kühlmittels oder die Temperatur des Mediums unter die vorgewählte Grenztemperatur absinkt.

Das Verfahren kann so ablaufen, dass die mehreren Stromoberschwingungen nicht zur Kompensation von Oberschwingungen in einem angeschlossenen Wechselspannungsnetz oder in einer angeschlossenen elektrischen Last benötigte Stromoberschwingungen sind.

Das Verfahren kann auch so ablaufen, dass die mehreren Stromoberschwingungen voneinander verschiedene Stromoberschwingungen n-ter Ordnung (zu der von dem Stromrichter zu erzeugenden Stromgrundschwingung) sind, wobei n jeweils ein ganzzahliges Vielfaches von 3 ist.

Das Verfahren kann so ablaufen, dass aufgrund der mindestens einen Stromoberschwingung ein innerhalb des Stromrichters fließender Kreisstrom gebildet wird (der den Stromrichter nicht verlässt).

Das Verfahren kann auch so ablaufen, dass in der Reihenschaltung die mindestens eine Stromoberschwingung nur dann erzeugt wird, wenn zusätzlich der (betriebsbedingt) in der Reihenschaltung fließende Betriebsstrom des Stromrichters einen Stromschwellenwert unterschreitet.

Die beschriebene Anordnung mit dem Stromrichter und das beschriebene Verfahren weisen gleiche beziehungsweise gleichartige Vorteile auf.

Im Folgenden wird die Erfindung anhand von Ausführungsbeispielen näher erläutert. Gleiche Bezugszeichen verweisen dabei auf gleiche bzw. gleichwirkende Elemente. Dazu ist in
- Figur 1: ein Ausführungsbeispiel einer Anordnung mit einem Stromrichter, der an ein Energieversorgungsnetz angeschlossen ist, in
- Figur 2: ein Ausführungsbeispiel des in Dreieckschaltung ausgestalteten Stromrichters, in
- Figur 3: ein Ausführungsbeispiel eines Phasenmoduls des Stromrichters, in
- Figur 4: ein Ausführungsbeispiel eines Moduls der elektrischen Reihenschaltung des Stromrichters, in
- Figur 5: ein Ausführungsbeispiel eines Powermoduls, welches einen Bestandteil des Moduls der Reihenschaltung bildet, in
- Figur 6: ein Ausführungsbeispiel eines Kondensatormoduls, welches einen Bestandteil des Moduls der Reihenschaltung bildet, in
- Figur 7: ein Ausführungsbeispiel einer Kühleinrichtung in Form einer Einkreis-Kühleinrichtung, und in
- Figur 8: ein Ausführungsbeispiel einer Oberschwingungseinheit dargestellt.

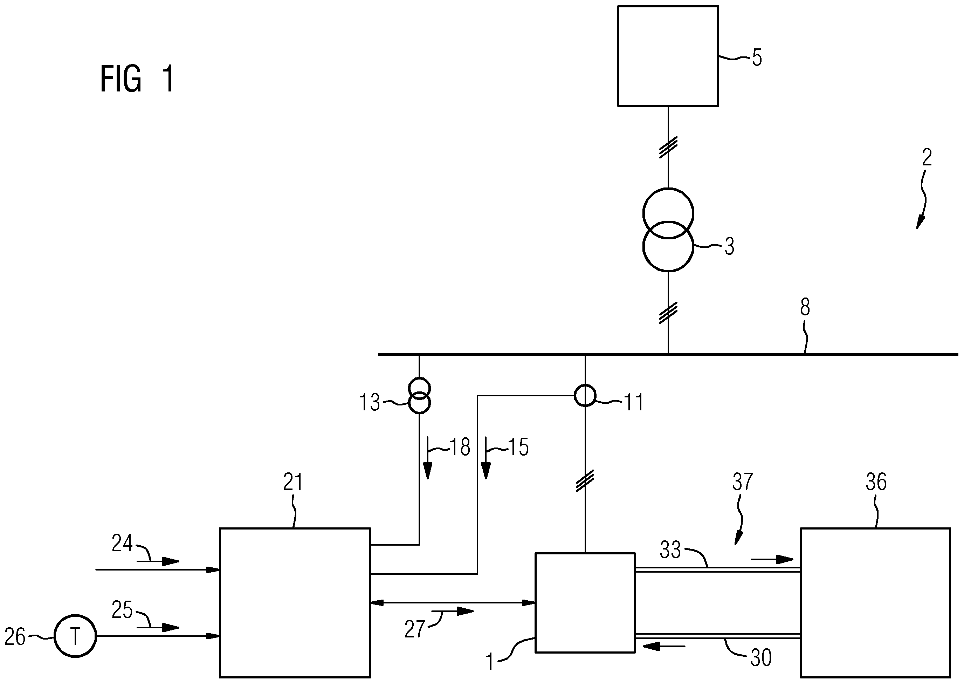

In Figur 1 ist eine Anordnung 2 mit einem Stromrichter 1 dargestellt, der über einen Transformator 3 an ein dreiphasiges elektrisches Wechselspannungsnetz 5 (Energieversorgungsnetz 5) angeschlossen ist. Eine dreiphasige elektrische Verbindung zwischen dem Stromrichter 1 und dem Transformator 3 ist mittels einer Anschlussschiene 8 hergestellt. Ein Stromsensor 11 dient zum Messen des zu dem Stromrichter 1 fließenden Stroms. Ein Spannungssensor 13 misst die an der Anschlussschiene 8 anliegende Spannung; diese Spannung entspricht der an dem Stromrichter 1 anliegenden Spannung. Strommesswerte 15 des Stromsensors 11 und Spannungsmesswerte 18 des Spannungssensors 13 werden zu einer Ansteuereinheit 21 übertragen. Anhand dieser Messwerte 15 und 18, anhand von Sollwerten 24 und anhand von Temperaturmesswerten 25 (die von einem Temperatursensor 26 stammen) erzeugt die Ansteuereinheit 21 Ansteuersignale 27 und steuert damit den Stromrichter 1 an. Dazu verarbeitet die Ansteuereinheit 21 die Strommesswerte 15, die Spannungsmesswerte 18 und die Temperaturmesswerte 25. Der Stromrichter 1 ist im Ausführungsbeispiel der Figur 1 ein Blindleistungskompensator, welcher die in der Anschlussschiene 8 und damit auch die in dem Wechselspannungs-Energieversorgungsnetz 5 auftretende Blindleistung gezielt beeinflussen kann. Der Stromrichter 1 ist im Ausführungsbeispiel als ein modularer Multilevel-Stromrichter 1 ausgestaltet.

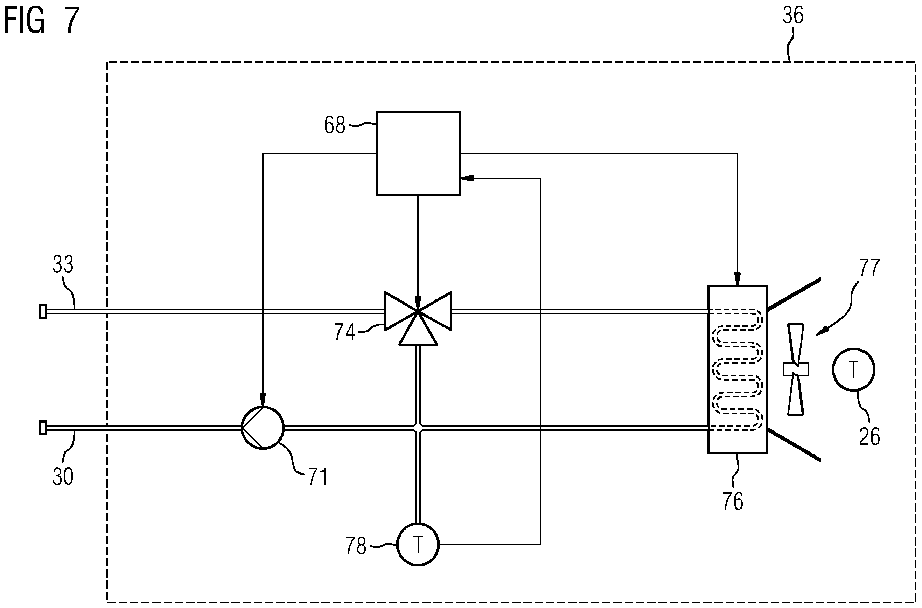

Der Stromrichter 1 ist über einen Kühlmittelzulauf 30 und einen Kühlmittelrücklauf 33 mit einer Kühleinrichtung 36 verbunden. In dem geschlossenen Kühlmittel-Kreislauf zirkuliert ein Kühlmittel 37. Das Kühlmittel 37 ist als ein flüssiges Kühlmittel (Kühlflüssigkeit) ausgebildet, insbesondere als ein wasserbasiertes flüssiges Kühlmittel wie zum Beispiel deionisiertes Wasser. Die Temperaturmesswerte 25 sind im Ausführungsbeispiel Messwerte der Temperatur eines Mediums, das an einem Wärmetauscher 76 (vergleiche Figur 7) der Kühleinrichtung 36 die Wärme aufnehmen soll. Alternativ oder zusätzlich können die Temperaturmesswerte 25 auch Messwerte der Temperatur des flüssigen Kühlmittels 37 (insbesondere Messwerte der Temperatur des flüssigen Kühlmittels an dem Wärmetauscher 76) sein.

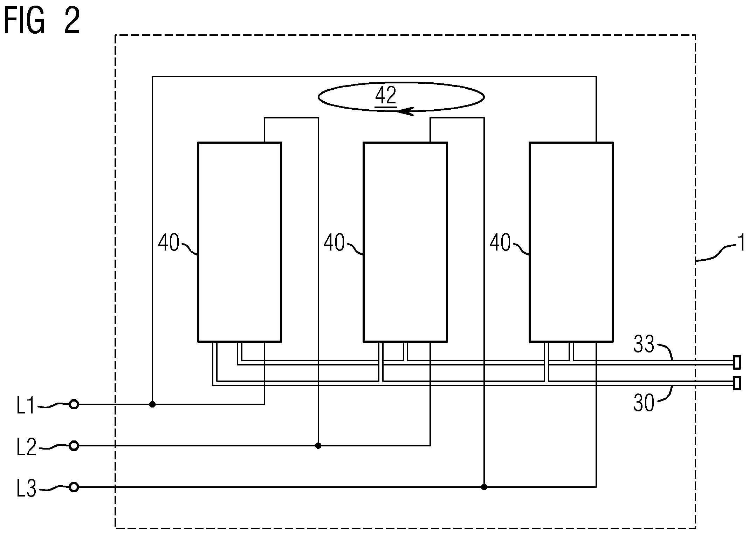

In Figur 2 ist ein Ausführungsbeispiel des Stromrichters 1 dargestellt, welcher drei Stromrichterzweige 40 aufweist. Die drei Stromrichterzweige 40 sind in einer Dreieckschaltung geschaltet und über drei Stromrichteranschlüsse L1, L2 und L3 mit den drei Phasen des dreiphasigen Wechselspannungsnetzes 5 verbindbar. Jeder Stromrichterzweig 40 ist über den Kühlmittelzulauf 30 und den Kühlmittelrücklauf 33 mit der Kühleinrichtung 36 verbunden. In dem Stromrichter 1 (hier: in der Dreieckschaltung der drei Stromrichterzweige 40) kann ein Kreisstrom 42 fließen, der den Stromrichter 1 nicht verlässt.

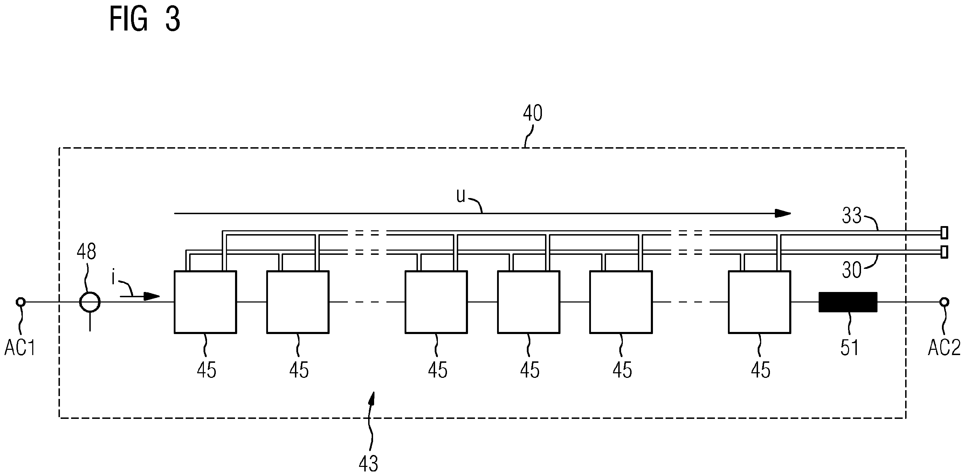

In Figur 3 ist ein Ausführungsbeispiel eines Stromrichterzweigs 40 dargestellt. Dieser Stromrichterzweig 40 weist einen ersten Zweiganschluss AC1 und einen zweiten Zweiganschluss AC2 auf. Zwischen den beiden Zweiganschlüssen AC1 und AC2 erstreckt sich eine elektrische Reihenschaltung 43 von Modulen 45. Optional weist die Reihenschaltung 43 weiterhin einen Stromsensor 48 zur Messung des durch den Stromrichterzweig 40 fließenden Stroms i sowie ein induktives Bauelement 51 (insbesondere eine Koppelinduktivität 51) auf. Über der Reihenschaltung 43 von Modulen 45 tritt die Spannung u auf. Jedes Modul 45 ist über den Kühlmittelzulauf 30 und den Kühlmittelrücklauf 33 mit der Kühleinrichtung 36 verbunden.

Im Ausführungsbeispiel kann der Stromrichterzweig beispielsweise 64 Module aufweisen. In anderen Ausführungsbeispielen kann der Stromrichterzweig natürlich auch eine andere Anzahl an Modulen aufweisen, beispielsweise 32 Module oder 128 Module. Der Stromrichterzweig 40 kann auch als ein Stromrichtermodul 40 bezeichnet werden.

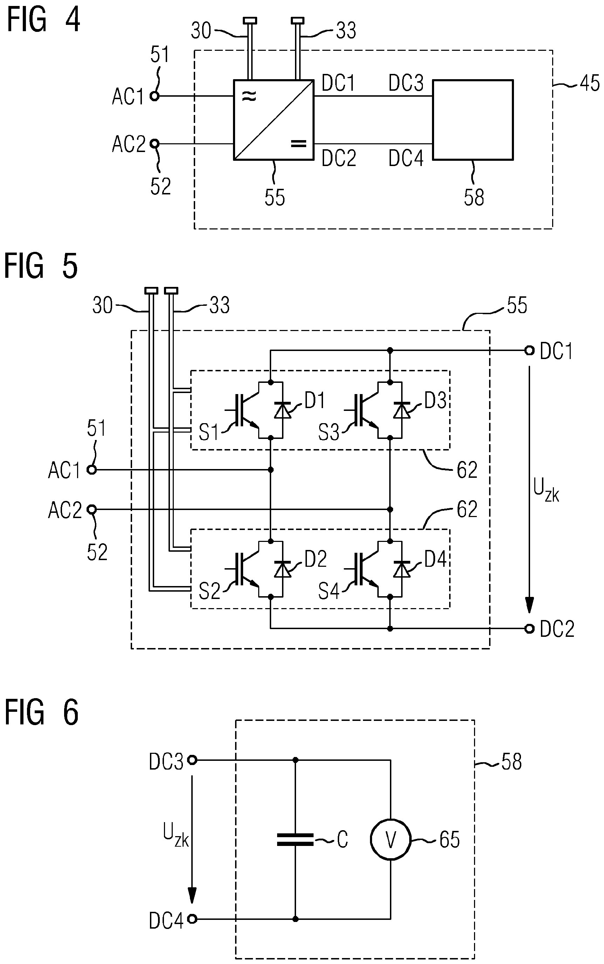

In Figur 4 ist ein Ausführungsbeispiel eines Moduls 45 dargestellt. Das Modul 45 weist zwei Modulanschlüsse 51 und 52 auf, welche mit einem sogenannten Powermodul 55 verbunden sind. Das Powermodul 55 weist weiterhin zwei Gleichspannungsanschlüsse DC1 und DC2 auf, welche mit zwei Gleichspannungsanschlüssen DC3 und DC4 eines Kondensatormoduls 58 elektrisch verbunden sind. Die Gleichspannungsanschlüsse DC1 und DC2 bilden einen Gleichspannungszwischenkreis des Moduls 45. Das Powermodul 55 ist über den Kühlmittelzulauf 30 und den Kühlmittelrücklauf 33 mit der Kühleinrichtung 36 verbunden.

In Figur 5 ist ein Ausführungsbeispiel des Powermoduls 55 dargestellt. Das Powermodul 55 weist vier elektronische Schaltelemente S1 - S4 (insbesondere Halbleiterschalter S1 - S4) auf. Das Powermodul kann auch als ein Schaltelementemodul 55 bezeichnet werden. Die vier elektronischen Schaltelemente S1 - S4 sind in einer Vollbrückenschaltung angeordnet. Zu den elektronischen Schaltelementen S1 - S4 ist jeweils eine Freilaufdiode D1 - D4 antiparallel geschaltet. Die elektronischen Schaltelemente können beispielsweise IGBTs, IGCTs, IEGTs oder MOSFETs sein. In Figur 5 ist zu erkennen, dass an den Anschlüssen DC1 und DC2 die Zwischenkreisspannung UZK auftritt.

Jedes der elektronischen Schaltelemente S1 - S4 ist mit einem Kühlkörper 62 (zum Beispiel mit einer Kühlplatte 62) thermisch verbunden. Der Kühlkörper 62 nimmt die in den elektronischen Schaltelementen (insbesondere durch elektrische Verluste) entstehende Wärme auf. Der Kühlkörper 62 gibt diese Wärme an das flüssige Kühlmittel 37 ab, welches über den Kühlmittelzulauf 30 von der Kühleinrichtung 36 zugeführt wird. Das erwärmte Kühlmittel wird daraufhin über den Kühlmittelrücklauf 33 zu der Kühleinrichtung 36 transportiert.

In Figur 6 ist ein Ausführungsbeispiel des Kondensatormoduls 58 dargestellt. Das Kondensatormodul 58 weist als Energiespeicher einen Kondensator C (der elektrische Energie zwischenspeichert und insbesondere die Zwischenkreisspannung UZK puffert) und optional eine dem Kondensator C parallel geschaltete Spannungsmesseinrichtung 65 auf.

In Figur 7 ist ein Ausführungsbeispiel der Kühleinrichtung 36 (Kühlanlage 36) dargestellt, die beispielhaft als eine Einkreis-Kühleinrichtung 36 ausgestaltet ist. Die Kühleinrichtung 36 weist eine Kühleinrichtungssteuerung 68, eine Pumpe 71, ein Dreiwegeventil 74 und einen Wärmetauscher 76 auf. Die Kühleinrichtungssteuerung 68 steuert die Pumpe 71 an, welche das Kühlmittel durch den Kühlkreislauf zu den elektronischen Schaltelementen S1 - S4 pumpt (Zirkulation des flüssigen Kühlmittels). Die Kühleinrichtungssteuerung 68 steuert auch das Dreiwegeventil 74 an. Die Kühleinrichtungssteuerung 68 steuert so die Menge des zu dem Wärmetauscher 76 fließenden Kühlmittels 37.

Der Wärmetauscher 76 steht in thermischen Kontakt mit einem Medium 77, das die vom Wärmetauscher abgegebene Wärme aufnehmen soll. Dieses am Wärmetauscher die Wärme aufnehmende Medium 77 ist im Ausführungsbeispiel Luft (Umgebungsluft). In anderen Ausführungsbeispielen kann aber auch ein anderes Medium verwendet werden, beispielsweise eine Flüssigkeit.

Der Wärmetauscher 76 weist einen elektrischen Lüfter auf, der von der Kühleinrichtungssteuerung 68 angesteuert wird. Der Lüfter transportiert die Luft durch den Wärmetauscher oder entlang des Wärmetauschers; die Luft nimmt dabei die Wärme des flüssigen Kühlmittels auf. Die Temperatur des Kühlmittels wird mittels eines Temperatursensors 78 gemessen; die gemessene Kühlmitteltemperatur wird von der Kühleinrichtungssteuerung 68 ausgewertet.

Weiterhin ist der Temperatursensor 26 (vgl. Figur 1) dargestellt. Der Temperatursensor 26 misst im Beispiel die Temperatur des an dem Wärmetauscher 76 die Wärme aufnehmenden Mediums (hier die Temperatur der den Wärmetauscher umgebenden Luft). Alternativ oder zusätzlich kann auch die Temperatur des Kühlmittels gemessen werden, insbesondere die Temperatur des Kühlmittels am Wärmetauscher 76.

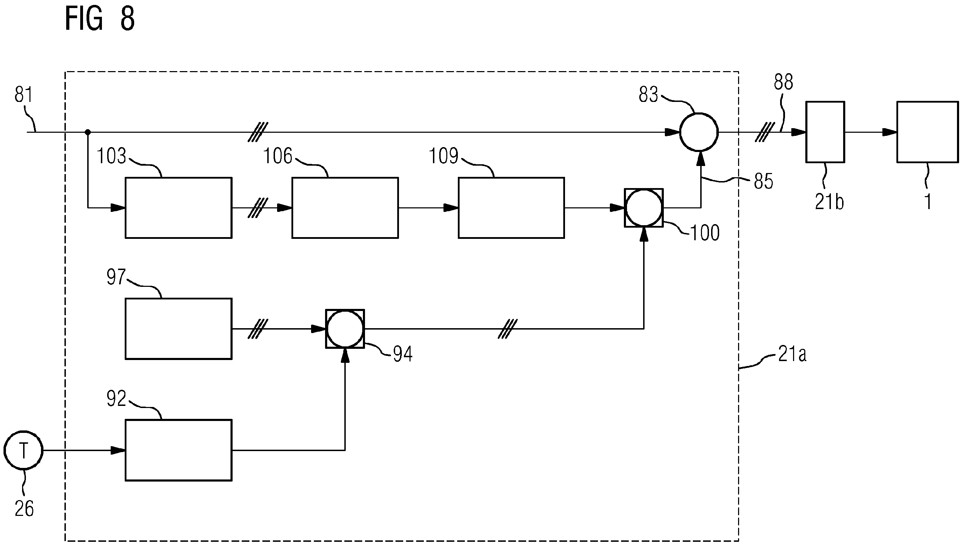

In Figur 8 ist ein Ausführungsbeispiel einer Oberschwingungseinheit 21a dargestellt, die zusammen mit einer Stromregeleinheit 21b Bestandteile der Ansteuereinheit 21 für den Stromrichter 1 sind. Die Oberschwingungseinheit 21a kann auch als eine Oberschwingungserzeugungseinheit oder als eine Oberwellenerzeugungseinheit bezeichnet werden.

Die Oberschwingungseinheit 21a empfängt ein dreiphasiges Stromanforderungssignal 81, welches den Strom beschreibt, den der Stromrichter 1 bereitstellen soll. Unter bestimmten Voraussetzungen (die nachfolgend näher erläutert werden) wird an einem Summationspunkt 83 zu dem Stromanforderungssignal 81 ein Oberwellensignal 85 addiert; es entsteht ein Stromsollwert-Signal 88, das zu der dreiphasigen Stromregeleinheit 21b übertragen wird.

Die von dem Temperatursensor 26 gemessene Temperatur (hier: die Temperatur des am Wärmetauscher die Wärme aufnehmenden Mediums oder die Temperatur des Kühlmittels am Wärmetauscher) wird in einem Vergleicher 92 mit der vorgewählten Grenztemperatur verglichen. Die vorgewählte Grenztemperatur ist insbesondere die Frostschutzgrenztemperatur des Kühlmittels.

Ist die von dem Temperatursensor 26 gemessene Temperatur gleich oder niedriger als die vorgewählte Grenztemperatur, dann wird am Ausgang des Vergleichers 92 ein Signal "1" ausgegeben, andernfalls wird ein Signal "0" ausgegeben. Dieses Ausgangssignal des Vergleichers 92 wird einem Eingang eines Multiplizierers 94 zugeführt. Ein zweiter Eingang des Multiplizierers 94 ist mit einem Ausgang eines Funktionsgenerators 97 verbunden. Der dreiphasige Funktionsgenerator 97 erzeugt drei Sinusschwingungen mit einer Frequenz, die einem ganzzahligen Vielfachen der dreifachen Frequenz einer Stromgrundschwingung entspricht. Die Stromgrundschwingung ist insbesondere die von dem Stromrichter zu erzeugende Stromgrundschwingung. Die Frequenz der Stromgrundschwingung kann dabei der Netzfrequenz des elektrischen Energieversorgungsnetzes 5 entsprechen. Die erzeugten Sinusschwingungen bilden den Vorgabewert für die in dem Stromrichter (zu Heizzwecken) zu erzeugenden Stromoberschwingungen. Die drei erzeugten Sinusschwingungen haben zueinander einen Phasenversatz von 120°.

Am Ausgang des Multiplizierers 94 wird also der Vorgabewert für die zu erzeugenden Sinusschwingungen ausgegeben oder das Signal "0". Die Ausgabe des Multiplizierers 94 wird einem Eingang eines weiteren Multiplizierers 100 zugeführt.

Aus dem dreiphasigen Stromanforderungssignal 81 wird in einem Effektivwertbildner 103 für jede Phase der Effektivwert ermittelt. Aus den drei Effektivwerten wird daraufhin in einem Minimumbildner 106 der kleinste Effektivwert ermittelt. Der dem Minimumbildner 106 nachgeschaltete Vergleicher 109 (Schwellwertbildner 109) gibt an seinem Ausgang ein Signal "1" aus, wenn der kleinste Effektivstrom kleiner ist als ein Stromschwellenwert. Der Stromschwellenwert beschreibt einen elektrischen Strom, der gerade zu so großen elektrischen Verlusten (und der damit einhergehenden Wärmeentwicklung) im Stromrichter führt, die ausreichen, um ein Einfrieren des Kühlmittels zu verhindern. Diese Verluste kann man als "notwendige Verluste" bezeichnen. Das Ausgangssignal des Vergleichers 109 wird einem weiteren Eingang des weiteren Multiplizierers 100 zugeführt.

Das Ausgangssignal des weiteren Multiplizierers 100 (Oberwellensignal 85) beschreibt den zusätzlichen Strom, der in dem Stromrichter fließen muss, um zusätzliche elektrische Verluste zu erzeugen und dadurch das Kühlmittel aufzuheizen. Das Ausgangssignal des weiteren Multiplizierers 100 wird beim Summationspunkt 83 zu dem Stromanforderungssignal 81 addiert; es entsteht das Stromsollwertsignal 88. Das dreiphasige Stromsollwertsignal wird dann der Stromregelung 21b zugeführt. Die Elemente 103, 106, 109 und 100 sind optional, sie können auch weggelassen werden. Dann wird das Ausgangssignal des Multiplizierers 94 unmittelbar zum Summationspunkt 83 geleitet.

Zum Betreiben der beschriebenen Anordnung bzw. des beschriebenen Stromrichters läuft folgendes Verfahren ab: Die Temperatur des flüssigen Kühlmittels 37 oder die Temperatur des Mediums 77, das am Wärmetauscher 76 die Wärme aufnehmen soll, wird ermittelt. Bei einem Absinken der Temperatur des Kühlmittels 37 oder der Temperatur des Mediums 77 unter eine vorgewählte Grenztemperatur werden die elektronischen Schaltelemente S1, S2, S3 und S4 so angesteuert, dass in der Reihenschaltung 43 mindestens eine Stromoberschwingung erzeugt wird. Diese Stromoberschwingung ist eine Stromoberschwingung n-ter Ordnung, wobei n ein ganzzahliges Vielfaches von 3 ist. In der Reihenschaltung 43 können auch mehrere Stromoberschwingungen erzeugt werden, wenn die Temperatur des Kühlmittels 37 oder die Temperatur des Mediums 77 unter die vorgewählte Grenztemperatur absinkt. Die mehreren Stromoberschwingungen sind voneinander verschiedene Stromoberschwingungen n-ter Ordnung, wobei n jeweils ein ganzzahliges Vielfaches von 3 ist.

Die mindestens eine Stromoberschwingung ist dabei nicht zur Kompensation von Oberschwingungen in dem angeschlossenen Wechselspannungsnetz 5 oder in einer angeschlossenen elektrischen Last vorgesehen, sondern (insbesondere ausschließlich) zum Aufheizen des flüssigen Kühlmittels. Aufgrund der mindestens einen Stromoberschwingung fließt innerhalb des Stromrichters 1 ein Kreisstrom 42, der den Stromrichter nicht verlässt. Dieser Kreisstrom ist ein stromrichterinterner Strom. Bei der Bildung der Stromoberschwingungen und/oder aufgrund des fließenden Kreisstroms entsteht in den elektronischen Schaltelementen eine elektrische Verlustleistung, welche das Kühlmittel erwärmt. Dadurch wird ein Einfrieren des Kühlmittels (insbesondere im Wärmetauscher 76) auch bei niedrigen Außentemperaturen/Temperaturen des wärmeaufnehmenden Mediums zuverlässig verhindert. Optional kann in der Reihenschaltung 43 die mindestens eine Stromoberschwingung nur dann erzeugt wird, wenn zusätzlich der in der Reihenschaltung 43 fließende Betriebsstrom des Stromrichters 1 einen Stromschwellenwert unterschreitet. In diesem Fall reicht der Betriebsstrom allein nicht aus, um das Kühlmittel ausreichend zu erwärmen. Deshalb werden die zusätzliche Stromoberschwingung/Stromoberschwingungen und damit der zusätzliche Kreisstrom erzeugt.

Es wurden eine Anordnung mit einem Stromrichter und ein Verfahren beschrieben, mit denen ein Stromrichter auch bei sehr niedrigen Außentemperaturen betrieben werden kann mit einem vergleichsweise geringen Anteil an Frostschutzmittel im flüssigen Kühlmittel. Dies erlaubt insbesondere den Betrieb eines dreiphasigen Multilevel-Stromrichters in Deltaschaltung mit einer Einkreiskühlanlage bei sehr niedrigen Außentemperaturen.

Der Stromrichter kann dabei beispielsweise als ein Blindleistungskompensator (insbesondere als ein Static Synchronous Compensator - STATCOM) arbeiten. Ein solcher Blindleistungskompensator wird nämlich in der Regel nur selten unter Volllast betrieben (d.h. bei voller Blindleistungsabgabe), sondern meistens arbeitet er im verlustarmen Leerlauf. Daher sind hier das beschriebene Verfahren und die beschriebene Anordnung besonders vorteilhaft einsetzbar.

Das beschriebene Verfahren und die beschriebene Anordnung ermöglichen insbesondere den Betrieb eines dreiphasigen Multilevel-Stromrichters in Deltaschaltung mit einer Einkreiskühlanlage, die einen geringeren Frostschutzmittelanteil aufweist, als es die tiefsten zu erwartenden Außentemperaturen erfordern würden. Dabei wird bei Außentemperaturen unterhalb der Frostschutzgrenztemperatur des Kühlmittels im Stromrichterleerlauf eine Stromoberschwingung, welche ein ganzzahliges Vielfaches der Ordnung 3 ist, vom Stromrichter erzeugt. Diese Stromoberschwingung ist vorzugsweise so gewählt, dass sie zusätzliche Verluste im Stromrichter erzeugt, die in etwa 10 % der Nenn-Stromrichterverluste entsprechen. Überraschenderweise hat sich nämlich gezeigt, dass dann die Kühlflüssigkeit mit einem eigentlich zu geringen Anteil an Frostschutzmittel nicht gefriert, sondern einen Eisbrei bildet, der mittels der Aufheizung durch die Stromoberschwingungen flüssig gehalten werden kann. Dadurch können Schäden an dem Wärmetauscher durch Eisbildung selbst dann verhindert werden, wenn die Außentemperaturen unter dem Gefrierpunkt der Kühlflüssigkeit liegen.

In einer besonderen Ausführung werden mehrere Stromoberschwingungen, welche ganzzahlige Vielfache der Ordnung 3 sind, erzeugt, um einen kleinen Effektivstrom im Stromrichter zu erzeugen, der eine hohe Schaltfrequenz in den Modulen des Multilevel-Stromrichters bedingt.

Die Anordnung mit dem Stromrichter und das Verfahren weisen eine Reihe von Vorteilen auf:
- es treten in der Kühleinrichtung nur geringe Druckverluste auf, weil das flüssige Kühlmittel aufgrund des niedrigen Anteils an Frostschutzmittel nur eine vergleichsweise geringe Viskosität aufweist,
- die Kühleinrichtung kann kostengünstig realisiert werden, insbesondere als Einkreis-Kühleinrichtung,
- da die Wärme gut von den elektrischen Schaltelementen des Stromrichters/Umrichters abgeführt werden kann, ist eine gute thermische Ausnutzung des Stromrichters möglich; eine überhitzungsbedingte Leistungsreduzierung des Stromrichters wird vermieden,
- aufgrund der niedrigeren Temperatur der gekühlten elektronischen Schaltelemente treten auch nur geringe elektrische Betriebsverluste des Stromrichters auf; es wird nur ein kleiner Wärmetauscher/Rückkühler benötigt und eine bessere Verlustbewertung des Stromrichters ist möglich und/oder
- die zusätzlichen (gewollten) elektrischen Verluste im Stromrichter (elektrische Heiz-Verluste) treten nur an sehr wenigen kalten Tagen auf (beispielsweise an Tagen mit Temperaturen kleiner als -40°C).

Ermöglicht wird vorteilhafterweise die Verwendung eines Kühlmittels mit einem geringeren Frostschutzmittelanteil, als es die tiefsten denkbaren Außentemperaturen erfordern würden. Wenn die Außentemperaturen unter die Frostschutzgrenze fallen, dann wird innerhalb des Stromrichters ein Oberschwingungsstrom erzeugt, der nicht ins Netz fließt und genügend elektrische Verluste erzeugt, um das Kühlmittel aufzuheizen. Zusätzlich kann mittels einer gezielten Durchmischung von heißem und kaltem Kühlmittel noch besser erreicht werden, dass das Kühlmittel flüssig bleibt.

Durch eine Wahl einer höheren Grenztemperatur kann der Anteil des Frostschutzmittels im Kühlmittel noch weiter reduziert werden und die Betriebsverluste des Stromrichters aufgrund der Viskosität des Kühlmittels können weiter gesenkt werden. Dann sind noch kleinere und kostengünstigere Rückkühler/Wärmetauscher ausreichend.

Teure Alternativen, wie zum Beispiel Nutzung einer Zweikreiskühlanlage, einer Einkreiskühlanlage mit höherem Anteil an Frostschutzmittel und Leistungsreduzierung des Stromrichters oder einer Einkreiskühlanlage mit einem separaten Zuheizer werden vorteilhafterweise vermieden. Diese kostenintensiven Alternativen sind nachfolgend kurz umrissen.
1. Zusetzen eines hohen Anteils an Frostschutzmittel (z.B. Monoethylenglykol oder Propylenglykol, allgemein: Glykol), was die thermische Ausnutzung der Leistungshalbleiter-Schaltelemente verschlechtert und bei sehr tiefen Außentemperaturen, z.B. unter -40°C, kaum noch einen sinnvollen Betrieb aufgrund der erforderlichen Leistungsreduzierung erlaubt.
2. Verwenden eines Zuheizers (elektrisch oder mit Brennstoff), der die Kühlflüssigkeit über den Gefrierpunkt hält. Dieser erfordert jedoch teure zusätzliche Geräte mit aufwändiger Versorgung.
3. Aufteilen des Kühlkreislaufs in zwei Kühlkreisläufe, die über einen zusätzlichen Wärmetauscher gekoppelt sind, wobei der innere Kreislauf den Stromrichter ohne Frostschutzmittel kühlt und der äußere mit einem sehr hohen

Frostschutzmittelanteil den im Freien stehenden Wärmetauscher an die Umgebungsluft koppelt. Durch die teure Doppelung von Wärmetauschern, Pumpen und Sensoren entstehen zusätzlich hohe Betriebsverluste in der Kühlanlage und der Aufwand durch Wartung steigt.

## Patentansprüche

1. Anordnung mit einem Stromrichter (1), der eine elektrische Reihenschaltung (43) von Modulen (45) aufweist, welche jeweils vier elektronische Schaltelemente (S1, S2, S3, S4) und einen elektrischen Energiespeicher (C) aufweisen, mit einer Kühleinrichtung (36) zum Kühlen der elektronischen Schaltelemente mittels eines flüssigen Kühlmittels (37) und eines Wärmetauschers (76) und mit einer Ansteuereinheit (21) zum Ansteuern der elektronischen Schaltelemente, die die elektronischen Schaltelemente so ansteuert, dass in der Reihenschaltung mindestens eine Stromoberschwingung erzeugt wird, wenn die Temperatur des flüssigen Kühlmittels (37) oder die Temperatur eines Mediums (77), das am Wärmetauscher die Wärme aufnehmen soll, unter eine vorgewählte Grenztemperatur absinkt, wobei der Stromrichter (1) in Dreieckschaltung ausgestaltet ist und die Stromoberschwingung eine Stromoberschwingung n-ter Ordnung ist, wobei n ein ganzzahliges Vielfaches von 3 ist.

2. Anordnung nach Anspruch 1,
**dadurch gekennzeichnet, dass**
- die vorgewählte Grenztemperatur die Frostschutzgrenztemperatur des Kühlmittels (37) ist.

3. Anordnung nach Anspruch 1 oder 2,
**dadurch gekennzeichnet, dass**
- die Stromoberschwingung eine nicht zur Kompensation von Oberschwingungen in einem angeschlossenen Wechselspannungsnetz (5) oder in einer angeschlossenen elektrischen Last benötigte Stromoberschwingung ist.

4. Anordnung nach einem der vorhergehenden Ansprüche,
**dadurch gekennzeichnet, dass**
- in der Reihenschaltung mehrere unterschiedliche Stromoberschwingungen erzeugt werden, wenn die Temperatur des Kühlmittels (37) oder des Mediums unter die vorgewählte Grenztemperatur absinkt.

5. Anordnung nach Anspruch 4,
**dadurch gekennzeichnet, dass**
- die mehreren Stromoberschwingungen nicht zur Kompensation von Oberschwingungen in einem angeschlossenen Wechselspannungsnetz (5) oder in einer angeschlossenen elektrischen Last benötigte Stromoberschwingungen sind.

6. Anordnung nach Anspruch 4 oder 5,
**dadurch gekennzeichnet, dass**
- die mehreren Stromoberschwingungen voneinander verschiedene Stromoberschwingungen n-ter Ordnung sind, wobei n jeweils ein ganzzahliges Vielfaches von 3 ist.

7. Anordnung nach einem der vorhergehenden Ansprüche,
**dadurch gekennzeichnet, dass**
- der Stromrichter (1) drei elektrische Reihenschaltungen (43) von Modulen (45) aufweist, die in der Dreieckschaltung angeordnet sind.

8. Anordnung nach einem der vorhergehenden Ansprüche,
**dadurch gekennzeichnet, dass**
- die mindestens eine Stromoberschwingung einen innerhalb des Stromrichters (1) fließenden Kreisstrom (42) bildet.

9. Anordnung nach einem der vorhergehenden Ansprüche,
**dadurch gekennzeichnet, dass**
- die Kühleinrichtung (36) eine Einkreis-Kühleinrichtung ist.

10. Anordnung nach einem der vorhergehenden Ansprüche,
**dadurch gekennzeichnet, dass**
- die Module (45) Vollbrückenmodule sind, bei denen die vier elektronischen Schaltelemente (S1, S2, S3, S4) in einer Vollbrückenschaltung angeordnet sind.

11. Anordnung nach einem der vorhergehenden Ansprüche,
**dadurch gekennzeichnet, dass**
- die elektrische Reihenschaltung (43) zusätzlich zu den Modulen ein induktives Bauelement (51) aufweist.

12. Anordnung nach einem der vorhergehenden Ansprüche,
**dadurch gekennzeichnet, dass**
- in der Reihenschaltung (43) die mindestens eine Stromoberschwingung nur dann erzeugt wird, wenn zusätzlich der in der Reihenschaltung (43) fließende Betriebsstrom des Stromrichters einen Stromschwellenwert unterschreitet.

13. Verfahren zum Betreiben einer Anordnung mit einem Stromrichter (1), der eine elektrische Reihenschaltung (43) von Modulen (45) aufweist, welche jeweils vier elektronische Schaltelemente (S1, S2, S3, S4) und einen elektrischen Energiespeicher (C) aufweisen, und mit einer Kühleinrichtung (36) zum Kühlen der elektronischen Schaltelemente mittels eines flüssigen Kühlmittels (37) und eines Wärmetauschers (76), wobei der Stromrichter (1) in Dreieckschaltung ausgestaltet ist, wobei bei dem Verfahren
- die Temperatur des flüssigen Kühlmittels (37) oder die Temperatur eines Mediums (77), das am Wärmetauscher (76) die Wärme aufnehmen soll, ermittelt wird, und
- bei einem Absinken der Temperatur des Kühlmittels (37) oder der Temperatur des Mediums (77) unter eine vorgewählte Grenztemperatur die elektronischen Schaltelemente (S1, S2, S3, S4) so angesteuert werden, dass in der Reihenschaltung (43) mindestens eine Stromoberschwingung erzeugt wird, wobei die Stromoberschwingung eine Stromoberschwingung n-ter Ordnung ist, wobei n ein ganzzahliges Vielfaches von 3 ist.

14. Verfahren nach Anspruch 13,
**dadurch gekennzeichnet, dass**
- in der Reihenschaltung (43) mehrere unterschiedliche Stromoberschwingungen erzeugt werden, wenn die Temperatur des Kühlmittels (37) oder des Mediums (77) unter die vorgewählte Grenztemperatur absinkt.

15. Verfahren nach Anspruch 13 oder 14,
**dadurch gekennzeichnet, dass**
- die mehreren Stromoberschwingungen nicht zur Kompensation von Oberschwingungen in einem angeschlossenen Wechselspannungsnetz (5) oder in einer angeschlossenen elektrischen Last benötigte Stromoberschwingungen sind.

16. Verfahren nach einem der Ansprüche 13 bis 15,
**dadurch gekennzeichnet, dass**
- die mehreren Stromoberschwingungen voneinander verschiedene Stromoberschwingungen n-ter Ordnung sind, wobei n jeweils ein ganzzahliges Vielfaches von 3 ist.

17. Verfahren nach einem der Ansprüche 13 bis 16,
**dadurch gekennzeichnet, dass**
- aufgrund der mindestens einen Stromoberschwingung ein innerhalb des Stromrichters (1) fließender Kreisstrom (42) gebildet wird.

18. Verfahren nach einem der Ansprüche 13 bis 17,
**dadurch gekennzeichnet, dass**
- in der Reihenschaltung (43) die mindestens eine Stromoberschwingung nur dann erzeugt wird, wenn zusätzlich der in der Reihenschaltung (43) fließende Betriebsstrom des Stromrichters (1) einen Stromschwellenwert unterschreitet.

## Claims

1. Arrangement having a power converter (1) that comprises an electrical series circuit (43) of modules (45) that each comprise four electronic switching elements (S1, S2, S3, S4) and an electrical energy store (C), with a cooling device (36) for cooling the electronic switching elements by means of a liquid coolant (37) and a heat exchanger (76), and with a drive unit (21) for driving the electronic switching elements which drives the electronic switching elements in such a way that at least one current harmonic is generated in the series circuit when the temperature of the liquid coolant (37), or the temperature of a medium (77) that is to absorb the heat at the heat exchanger, falls below a preselected limit temperature, wherein the power converter (1) is designed as a circuit with a delta configuration and the current harmonic is an nth order current harmonic, where n is an integer multiple of 3.

2. Arrangement according to Claim 1,
**characterized in that**
- the preselected limit temperature is the frost protection limit temperature of the coolant (37).

3. Arrangement according to Claim 1 or 2,
**characterized in that**
- the current harmonic is a current harmonic that is not needed for the compensation of harmonics in a connected AC voltage grid (5) or in a connected electrical load.

4. Arrangement according to one of the preceding claims,
**characterized in that**
- multiple different current harmonics are generated in the series circuit when the temperature of the coolant (37) or of the medium falls below the preselected limit temperature.

5. Arrangement according to Claim 4,
**characterized in that**
- the multiple current harmonics are current harmonics that are not needed for the compensation of harmonics in a connected AC voltage grid (5) or in a connected electrical load.

6. Arrangement according to Claim 4 or 5,
**characterized in that**
- the multiple current harmonics are nth order current harmonics that are different from one another, wherein n is an integer multiple of 3 in each case.

7. Arrangement according to one of the preceding claims,
**characterized in that**
- the power converter (1) comprises three electrical series circuits (43) of modules (45) configured as a delta circuit.

8. Arrangement according to one of the preceding claims,
**characterized in that**
- the at least one current harmonic forms a circulating current (42) flowing within the power converter (1).

9. Arrangement according to one of the preceding claims,
**characterized in that**
- the cooling device (36) is a single-circuit cooling device.

10. Arrangement according to one of the preceding claims,
**characterized in that**
- the modules (45) are full-bridge modules in which the four electronic switching elements (S1, S2, S3, S4) are arranged in a full-bridge circuit.

11. Arrangement according to one of the preceding claims,
**characterized in that**
- the electrical series circuit (43) comprises an inductive component (51) in addition to the modules.

12. Arrangement according to one of the preceding claims,
**characterized in that**
- the at least one current harmonic in the series circuit (43) is only generated when, in addition, the operating current of the power converter flowing in the series circuit (43) falls below a current threshold value.

13. Method for operating an arrangement with a power converter (1) that comprises an electrical series circuit (43) of modules (45) that each comprise four electronic switching elements (S1, S2, S3, S4) and an electrical energy store (C), and with a cooling device (36) for cooling the electronic switching elements by means of a liquid coolant (37) and a heat exchanger (76), wherein the power converter (1) is designed as a circuit with a delta configuration, wherein, in the method,
- the temperature of the liquid coolant (37) or the temperature of a medium (77) that is to absorb the heat at the heat exchanger (76) is ascertained, and
- when the temperature of the coolant (37) or the temperature of the medium (77) falls below a preselected limit temperature, the electronic switching elements (S1, S2, S3, S4) are driven such that at least one current harmonic is generated in the series circuit (43), wherein the current harmonic is an nth order current harmonic, where n is an integer multiple of 3.

14. Method according to Claim 13,
**characterized in that**
- multiple different current harmonics are generated in the series circuit (43) when the temperature of the coolant (37) or of the medium (77) falls below the preselected limit temperature.

15. Method according to Claim 13 or 14,
**characterized in that**
- the multiple current harmonics are current harmonics that are not needed for the compensation of harmonics in a connected AC voltage grid (5) or in a connected electrical load.

16. Method according to one of Claims 13 to 15,
**characterized in that**
- the multiple current harmonics are nth order current harmonics that are different from one another, where n is an integer multiple of 3 in each case.

17. Method according to one of Claims 13 to 16,
**characterized in that**
- due to the at least one current harmonic, a circulating current (42) is formed flowing within the power converter (1).

18. Method according to one of Claims 13 to 17,
**characterized in that**
- the at least one current harmonic in the series circuit (43) is only generated when, in addition, the operating current of the power converter (1) flowing in the series circuit (43) falls below a current threshold value.

## Revendications

1. Agencement comprenant un convertisseur (1), qui a un circuit (43) électrique série de modules (45), qui ont respectivement quatre éléments (S1, S2, S3, S4) électroniques de coupure et un accumulateur (C) d'énergie électrique, comprenant un dispositif (36) de refroidissement pour le refroidissement des éléments électroniques de coupure, au moyen d'un réfrigérant (37) liquide et d'un échangeur de chaleur (76), et comprenant une unité (21) de commande pour la commande des éléments électroniques de coupure, qui commande les éléments électroniques de coupure de manière à produire, dans le circuit série, au moins un harmonique de courant, si la température du réfrigérant (37) liquide ou la température d'un milieu (77), qui à l'échangeur de chaleur doit absorber la chaleur, s'abaisse en dessous d'une température limite choisie à l'avance, dans lequel le convertisseur (1) est conformé en circuit en triangle et l'harmonique de courant est un harmonique de courant d'ordre n, n étant un multiple en nombre entier de 3.

2. Agencement suivant la revendication 1,
**caractérisé en ce que**
- la température limite choisie à l'avance est la température limite d'antigel du réfrigérant (37).

3. Agencement suivant la revendication 1 ou 2,
**caractérisé en ce que**
- l'harmonique de courant est un harmonique de courant, qui n'est pas nécessaire à la compensation d'harmoniques dans un réseau (5) raccordé en tension alternative ou dans une charge électrique raccordée.

4. Agencement suivant l'une des revendications précédentes,
**caractérisé en ce que**
- il est produit, dans le circuit série, plusieurs harmoniques de courant différents, si la température du réfrigérant (37) ou du milieu s'abaisse en dessous de la température limite choisie à l'avance.

5. Agencement suivant la revendication 4,
**caractérisé en ce que**
- les plusieurs harmoniques de courant sont des harmoniques de courant, qui ne sont pas nécessaires à la compensation d'harmoniques dans un réseau (5) raccordé en tension alternative ou dans une charge électrique raccordée.

6. Agencement suivant la revendication 4 ou 5,
**caractérisé en ce que**
- les plusieurs harmoniques de courant sont des harmoniques de courant distincts l'un de l'autre d'ordre n, n étant respectivement un multiple en nombre entier de 3.

7. Agencement suivant l'une des revendications précédentes,
**caractérisé en ce que**
- le convertisseur (1) a trois circuits (43) électriques série de modules (45), qui sont montés suivant un circuit en triangle.

8. Agencement suivant l'une des revendications précédentes,
**caractérisé en ce que**
- le au moins un harmonique de courant forme un courant (42) circulaire passant à l'intérieur du convertisseur (1).

9. Agencement suivant l'une des revendications précédentes,
**caractérisé en ce que**
- le dispositif (36) de refroidissement est un dispositif de refroidissement à circuit unique.

10. Agencement suivant l'une des revendications précédentes,
**caractérisé en ce que**
- les modules (45) sont des modules à pont complet, dans lesquels les quatre éléments (S1, S2, S3, S4) électroniques de coupure sont montés suivant un circuit à pont complet.

11. Agencement suivant l'une des revendications précédentes,
**caractérisé en ce que**
- le circuit (43) électrique série a, en plus des modules, un composant (51) inductif.

12. Agencement suivant l'une des revendications précédentes,
**caractérisé en ce que**
- il n'est produit, dans le circuit (43) série, le au moins un harmonique de courant, que si en outre le courant de fonctionnement, passant dans le circuit (43) série, du convertisseur est inférieur à une valeur de seuil de courant

13. Procédé pour faire fonctionner un agencement comprenant un onduleur (1), qui a un circuit (43) électrique série de modules (45), qui ont respectivement quatre éléments (S1, S2, S3, S4) électroniques de coupure et un accumulateur (C) d'énergie électrique, comprenant un dispositif (36) de refroidissement pour le refroidissement des éléments électroniques de coupure, au moyen d'un réfrigérant (37) liquide et d'un échangeur de chaleur (76), dans lequel l'onduleur (1) est conformé en circuit en triangle, dans lequel dans le procédé
- on détermine la température du réfrigérant (37) liquide ou la température d'un milieu (77), qui doit absorber la chaleur à l'échangeur de chaleur (76), et
- si la température du réfrigérant (37) s'abaisse ou si la température du milieu (77) est en dessous d'une température limite choisie à l'avance, on commande les éléments (S1, S2, S3, S4) électroniques de coupure de manière à produire, dans le circuit (43) série, au moins un harmonique de courant, dans lequel l'harmonique de courant est un harmonique de courant d'ordre n, n étant un multiple en nombre entier de 3.

14. Procédé suivant la revendication 13,
**caractérisé en ce que**
- l'on produit dans le circuit (43) série plusieurs harmoniques de courant différents, si la température du réfrigérant (37) ou du milieu (77) s'abaisse en dessous de la température limite choisie à l'avance.

15. Procédé suivant la revendication 13 ou 14,
**caractérisé en ce que**
- l'harmonique de courant est un harmonique de courant, qui n'est pas nécessaire à la compensation d'harmoniques dans un réseau (5) raccordé en tension alternative ou dans une charge électrique raccordée.

16. Procédé suivant l'une des revendications 13 à 15,
**caractérisé en ce que**
- les plusieurs harmoniques de courant sont des harmoniques de courant distincts l'une de l'autre d'ordre n, n étant respectivement un multiple en nombre entier de 3.

17. Procédé suivant l'une des revendications 13 à 16,
**caractérisé en ce que**
- l'on forme un courant (42) circulaire, passant à l'intérieur du convertisseur (1), sur la base du au moins un harmonique de courant.

18. Procédé suivant l'une des revendications 13 à 17, **caractérisé en ce que**
- l'on ne produit, dans le circuit (43) série, le au moins un harmonique de courant, que si en outre le courant de fonctionnement, passant dans le circuit (43) série, du convertisseur (1) est inférieur à une valeur de seuil de courant.
